(19)

Europäisches Patentamt
European Patent Office
Office européen des brevets

(11) **EP 1 786 102 A1**

(12) **EUROPEAN PATENT APPLICATION**
published in accordance with Art. 158(3) EPC

(43) Date of publication:
**16.05.2007 Bulletin 2007/20**

(21) Application number: **05774563.0**

(22) Date of filing: **26.08.2005**

(51) Int Cl.:
*H03H 17/02* (2006.01)     *H03H 17/04* (2006.01)
*H03M 3/02* (2006.01)

(86) International application number:
**PCT/JP2005/015564**

(87) International publication number:
**WO 2006/022382 (02.03.2006 Gazette 2006/09)**

(84) Designated Contracting States:
**DE FR GB**

(30) Priority: **26.08.2004 JP 2004246168**

(71) Applicant: **Pioneer Corporation**
**Tokyo 153-8654 (JP)**

(72) Inventor: **HIGUCHI, Kohji,**
**The Univ. Electro-Communications**
**Chofu-shi, Tokyo182-8585 (JP)**

(74) Representative: **Sajda, Wolf E. et al**
**MEISSNER, BOLTE & PARTNER**
**Postfach 86 06 24**
**81633 München (DE)**

(54) **DIGITAL FILTER**

(57)     An object of the present invention is to provide a digital filter which allows for separately and independently adjusting and designing an intended filter characteristic and a filter characteristic for eliminating noise components.

The digital filter is configured to include a main filter section (12), having a transfer function G(z), for applying an intended filter characteristic to an input signal X sampled at a frequency higher than the Nyquist frequency for output; a quantizer section (13) for re-quantizing an output D2 from the main filter section (12) to output an output signal Y; a sub-filter section (14), having an inverse transfer function $G^{-1}(z)$ from the transfer function G(z) of the main filter section (12), for filtering the output signal Y; a noise shaping section (16) having a transfer function K(z) created by allowing a transfer function W(z) of a low-band rejection filter to be subtracted from 1, the low-band rejection filter having a low-band rejection characteristic in a predetermined frequency band of a noise component including a quantization error Q(z); an addition section (11) for adding the input signal X and an output D5 from the noise shaping section (16) for delivery to the main filter section (12); and a subtracter section (15) for computing the difference between a sum signal D1 and an output D3 from the sub-filter section (14) to supply a differential signal D4 to the noise shaping section (16).

*FIG.3*

EP 1 786 102 A1

**Description**

TECHNICAL FIELD

The present invention relates to a digital filter used in a digital signal processing system.

BACKGROUND ART

These days, digital signal processing systems employed in the fields of audio signal processing, image processing, telecommunications, automatic control and the like have brought widespread use of digital filters which are capable of performing intended signal processing by digital operations.

On the other hand, attention has been focused on such techniques as the oversampling technique for allowing signals being processed to be sampled at a frequency higher than the Nyquist frequency, the noise shaping technique for reducing quantization noise (quantumized error) or the like, and the Delta-Sigma modulation scheme (also referred to as the Sigma-Delta modulation scheme). Those digital filters that employ these digital signal processing technologies have been suggested.

For example, in the field of digital audio, in a non-patent literature suggested is a digital audio filter, configured as shown in Fig. 1, which employs these oversampling technique, noise shaping technique, and Delta-Sigma modulation scheme.

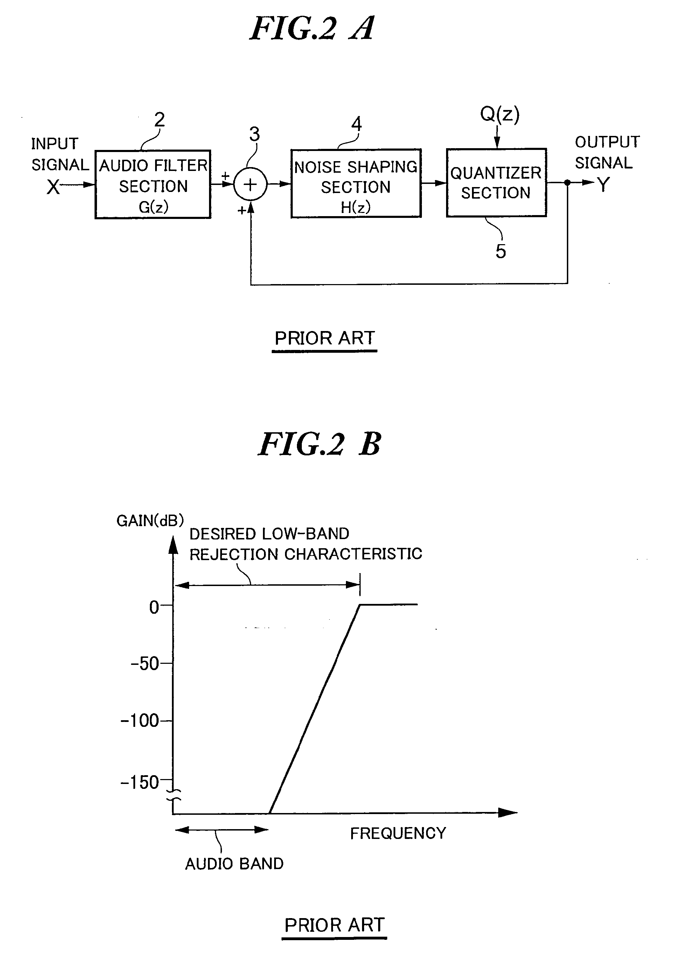

As shown in Fig. 2A the digital audio filter 1 has an improved configuration based on the configuration of a typical digital audio filter which includes an audio filter section 2 for applying an intended filter characteristic to an input signal X to adjust gain and phase characteristics or the like; an adder 3; a noise shaping section 4 made up of a low-pass filter and a band-pass filter which are adapted for the audio band; and a quantizer section 5. The digital audio filter 1 receives a one-bit stream digital audio signal of PWM (Pulse Width Modulation) modulated waves or PDM (Pulse Density Modulation) modulated waves, which has been oversampled at a frequency higher than the Nyquist frequency, as an input signal (hereinafter referred to as the "one-bit input signal") X. The digital audio filter 1 also performs predetermined digital filtering operations on the one-bit input signal X and then re-quantizes it into a one-bit stream digital audio signal to output the re-quantized signal as a one-bit output signal Y.

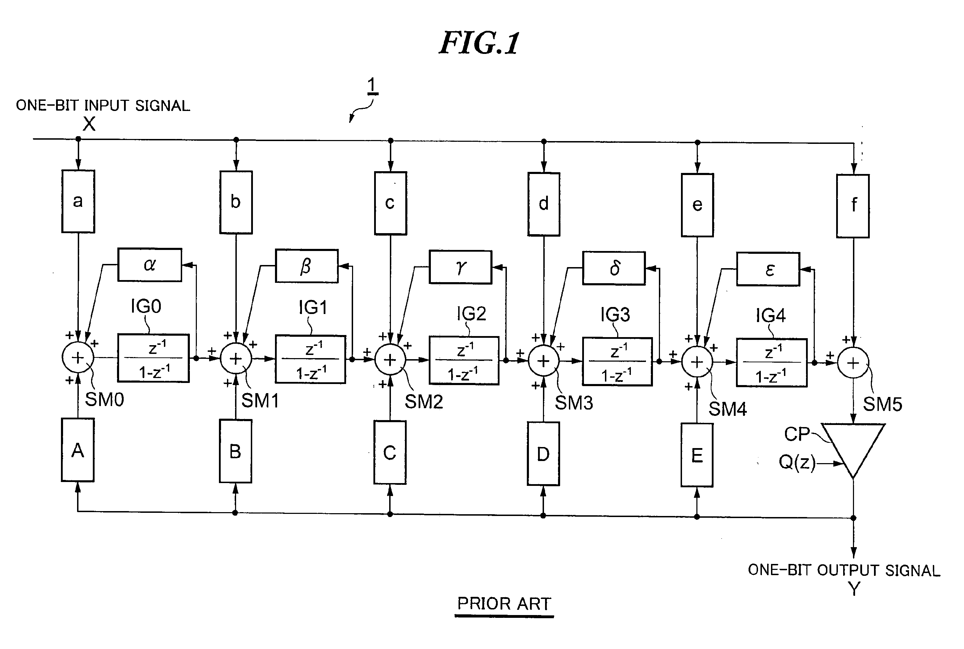

That is, the digital audio filter 1 shown in Fig. 1 can be configured as an nth order digital filter (n is an arbitrary natural number), and has been suggested, by way of example, as a fifth order digital filter. The digital audio filter 1 is further configured such that integrators IG0 to IG4 and adders SM0 to SM5, which are connected in series with each other, and scale multipliers a to f, A to E, and $\alpha$ to $\varepsilon$ realize a configuration corresponding to the audio filter section 2, the adder 3, and the noise shaping section 4 as shown in Fig. 2A. The digital audio filter 1 is also configured to include a comparator CP that corresponds to the quantizer section 5 shown in Fig. 2A.

Then, the digital audio filter 1 can define the filter characteristic for the one-bit input signal X by mainly adjusting respective coefficient values of the scale multipliers a to f and A to E, and can confine noise components such as quantization noise within a frequency band higher than the audio band by mainly adjusting respective coefficient values of the scale multipliers $\alpha$ to $\varepsilon$. That is, the digital audio filter 1 is adapted to output a noise-shaped one-bit output signal Y from the comparator CP. Accordingly, it is possible to eliminate noise components such as quantization noise by passing the one-bit output signal Y through a low-pass filter which has a high-band cutoff frequency at the upper limit of the audio band.

According to the conventional digital audio filter 1 configured as above, the scale multipliers a to f shown in Fig. 1 only have to multiply the one-bit input signal X of a one-bit data train by a coefficient value of multiple-bit (hereinafter referred to as "multi-bit") data. Likewise, the scale multipliers A to E also only have to multiply the one-bit output signal Y of a one-bit data train by a coefficient value of multi-bit data. Thus, this eliminates the need to form each of the scale multipliers a to f and A to E using a multiplier that multiplies multi-bit data by multi-bit data, thereby making it possible to reduce components and simplify the overall configuration.

Then, for example, the digital audio filter 1 performs digital filtering on a one-bit input signal X of a one-bit stream that has been read on a storage medium such as a CD (Compact Disc) or a one-bit input signal X obtained by being converted from analog to digital by a one-bit A/D converter that employs the Delta-Sigma modulation scheme. The digital audio filter 1 also outputs a one-bit output signal Y that has been re-quantized by the comparator CP. This makes it possible to construct a digital audio signal processing system which allows the input and output signals X and Y to remain in the form of one-bit stream during their processing.

[Non-Patent Document 1] N. M. CASEY and JAMES A. S. ANGUS. "One Bit Digital Processing Audio Signals" Proc. Audio Eng. 95th AES Convention 1993, New York

DISCLOSURE OF THE INVENTION

PROBLEMS TO BE SOLVED BY THE INVENTION

Meanwhile, as described above, the conventional digital audio filter 1 shown in Fig. 1 has an improved configuration to provide the filter characteristics corresponding to those of such a typical digital audio filter as shown in Fig. 2A, and is thus represented by the transfer function of the typical digital audio filter.

That is, assuming that the one-bit input signal X is X(z) on the z-plane, the one-bit output signal Y is Y(z), the audio filter section 2 shown in Fig. 2A is a transfer function G(z), the noise shaping section 4 is a transfer function H(z) such as of a low-pass filter, and quantization noise caused in the quantizer section 5 is Q(z), the relation of the one-bit output signal Y(z) to the one-bit input signal X(z) can be expressed by Equation (1) below.

Equation 1

$$ Y(z) = \frac{G(z)H(z)X(z)}{1 + H(z)} + \frac{Q(z)}{1 + H(z)} \qquad \cdots (1) $$

Here, Equation (1) above shows that the transfer function for the one-bit input signal X(z) at the first term on the right-hand side is expressed by the multiplicative and divisional relation between the transfer function G(z) of the audio filter section 2 and the transfer function H(z) of the noise shaping section 4. It is also shown that the transfer function for the quantization noise Q(z) at the second term on the right-hand side is expressed by the divisional relation with the transfer function H(z) of the noise shaping section 4.

These relations thus show that an adjustment or the like made to the transfer function H(z) of the noise shaping section 4 at the second term would cause the transfer function G(z) of the audio filter section 2 to be affected by the transfer function H(z) and thus substantially changed, thereby resulting in a change in the audio filter characteristic for the one-bit input signal X(z).

Furthermore, the digital audio filter 1 has a feature that since the scale multipliers a to f, A to E, and $\alpha$ to $\varepsilon$ shown in Fig. 1 are provided in order to realize the transfer functions of the first term and the second term, each coefficient value of these scale multipliers a to f, A to E, and $\alpha$ to $\varepsilon$ has complicated effects on both the transfer function G(z) of the audio filter section 2 and the transfer function H(z) of the noise shaping section 4.

Accordingly, in practice, separate adjustments made to the coefficient values of the scale multipliers a to f and A to E and the coefficient values of the scale multipliers $\alpha$ to $\varepsilon$ would make it difficult to define desired characteristics for each filter characteristic (e.g., gain and phase versus frequency characteristics) of the audio filter section 2 and the noise shaping section 4. It is thus required to make total adjustments in consideration of the effects exerted between all the coefficient values of the scale multipliers a to f, A to E, and $\alpha$ to $\varepsilon$, thereby causing adjustments or design works to be significantly complicated.

More specifically, as schematically shown in Fig. 2B, an attempt was made to design the noise shaping section 4 which provided a desired low-band rejection characteristic for a noise component such as a quantization error. In this case, there was a problem that an adjustment made to the transfer function H(z) of the noise shaping section 4, e.g., to change the low-band rejection characteristic caused the resulting transfer function H(z) to have effects on the transfer function G(z) of the audio filter section 2 from the relation given by Equation (1) above. For example, this resulted in changes in the cutoff frequency or the cutoff characteristic of the audio filter section 2 and the noise shaping section 4, thereby adversely affecting the one-bit input signal X.

An attempt was also made to define a desired filter characteristic corresponding to the transfer functions G(z) and H(z) by performing computer simulations to determine the coefficient values of the scale multipliers a to f, A to E, and $\alpha$ to $\varepsilon$. In this case, there were problems that to optimize these many coefficient values that simultaneously affected both the transfer functions G(z) and H(z), enormous and long-duration processing was required, while to realize the digital audio filter 1 which had a stable frequency versus gain and phase relation, more enormous and longer-duration processing was required.

The present invention was developed in view of such conventional problems. It is an object of the present invention to provide a digital filter which allows for separately and independently adjusting and designing an intended filter characteristic and a filter characteristic for noise shaping, and a method for designing the same.

It is also an object of the present invention to provide a simply configured digital filter which allows for separately and independently adjusting and designing an intended filter characteristic and a filter characteristic for noise shaping, and a method for designing the same.

MEANS FOR SOLVING THE PROBLEMS

The invention as set forth in claim 1 is to provide a digital filter for applying an intended filter characteristic to an input signal sampled at a frequency higher than the Nyquist frequency for output. The digital filter is characterized by comprising: main filter means, having a transfer function which provides an intended filter characteristic, for filtering an input signal based on the transfer function; quantization means for re-quantizing an output from the main filter means to output an output signal; sub-filter means, having an inverse transfer function from the transfer function of the main filter means, for filtering the output signal based on the inverse transfer function; noise shaping means, having a transfer function created by allowing a transfer function of a low-band rejection filter to be subtracted from 1, for filtering an input signal based on the transfer function, the low-band rejection filter having a low-band rejection characteristic in a predetermined frequency band of a noise component including a quantization error caused at the quantization means; first computation means for adding the input signal and an output from the noise shaping means to supply the resulting sum signal to the main filter means; and second computation means for computing the difference between the sum signal supplied to the main filter means and the output from the sub-filter means to supply the resulting differential signal to the noise shaping means.

The invention as set forth in claim 2 is to provide the digital filter according to claim 1, characterized in that the noise shaping means is formed of a removably connected unit.

The invention as set forth in claim 3 is to provide the digital filter according to claim 1 or 2, characterized in that the transfer function of the low-band rejection filter is configured to be expressed by a transfer function $(z-1)^n/(z-p)^n$ on the z-plane, where an arbitrary natural number n is its order and a coefficient p corresponds to its pole.

The invention as set forth in claim 4 is to provide a digital filtering method for applying an intended filter characteristic to an input signal sampled at a frequency higher than the Nyquist frequency for output. The method is characterized by comprising: a main filter process, having a transfer function which provides an intended filter characteristic, for filtering an input signal based on the transfer function; a quantization process for re-quantizing an output created in the main filter process to output an output signal; a sub-filter process, having an inverse transfer function from the transfer function in the main filter process, for filtering the output signal based on the inverse transfer function; a noise shaping process, having a transfer function created by allowing a transfer function of a low-band rejection filter to be subtracted from 1, for filtering an input signal based on the transfer function, the low-band rejection filter having a low-band rejection characteristic in a predetermined frequency band of a noise component including a quantization error caused in the quantization process; a first computation process for adding the input signal and an output created in the noise shaping process to supply the resulting sum signal to the main filter process; and a second computation process for computing the difference between the sum signal supplied to the main filter process and the output produced in the sub-filter process to supply the resulting differential signal to the noise shaping process.

The invention as set forth in claim 5 is to provide a computer program which realizes a digital filter for applying an intended filter characteristic to an input signal sampled at a frequency higher than the Nyquist frequency for output. The computer program is characterized by comprising: a main filter step, having a transfer function which provides an intended filter characteristic, for filtering an input signal based on the transfer function; a quantization step for re-quantizing an output created in the main filter step to output an output signal; a sub-filter step, having an inverse transfer function from the transfer function in the main filter step, for filtering the output signal based on the inverse transfer function; a noise shaping step, having a transfer function created by allowing a transfer function of a low-band rejection filter to be subtracted from 1, for filtering an input signal based on the transfer function, the low-band rejection filter having a low-band rejection characteristic in a predetermined frequency band of a noise component including a quantization error caused in the quantization step; a first computation step for adding the input signal and an output created in the noise shaping step to supply the resulting sum signal to the main filter step; and a second computation step for computing the difference between the sum signal supplied to the main filter step and the output produced in the sub-filter step to supply the resulting differential signal to the noise shaping step.

The invention as set forth in claim 6 is to provide a method for designing a digital filter which applies an intended filter characteristic to an input signal sampled at a frequency higher than the Nyquist frequency for output. The digital filter includes: main filter means having a transfer function which provides an intended filter characteristic for an input signal; quantization means for re-quantizing an output from the main filter means to output an output signal; sub-filter means for filtering the output signal for output; computation means for computing the difference between the signal supplied to the main filter means and the output from the filter means to output the resulting differential signal; noise shaping means for filtering the differential signal for output; and another computation means for adding an output from the noise shaping means and the input signal for delivery to the main filter means. The method is characterized by comprising the steps of: creating sub-filter means, having an inverse transfer function from the transfer function of the main filter means, for filtering the output signal based on the inverse transfer function; and creating a transfer function of the noise shaping means by appropriately determining a transfer function of a low-band rejection filter having a low-band rejection characteristic in a frequency band in which a noise component including a quantization error is caused, and by subtracting the transfer function of the low-band rejection filter from 1.

The invention as set forth in claim 7 is to provide the method for designing a digital filter according to claim 6, characterized in that the noise shaping means is formed of a removably connected unit.

The invention as set forth in claim 8 is to provide the method for designing a digital filter according to claim 6 or 7, characterized in that the transfer function of the low-band rejection filter is configured to be expressed by a transfer function $(z-1)^n/(z-p)''$ on the z-plane, where an arbitrary natural number n is its order and a coefficient p corresponds to its pole.

The invention as set forth in claim 9 is to provide the method for designing a digital filter according to claim 8, characterized by further comprising the steps of: creating an open loop transfer function $K(z)/(1-K(z))$ based on a transfer function $K(z)$ obtained by subtracting the transfer function $(z-1)^n/(z-p)^n$ of the low-band rejection filter from 1; varying a coefficient p in the open loop transfer function $K(z)/(1-K(z))$ as a parameter within the range of from -1 to +1; determining a coefficient p in the open loop transfer function $K(z)/(1-K(z))$ with a phase margin based on frequency versus gain and frequency versus phase relations; and determining a transfer function of the low-band rejection filter by employing the resulting coefficient p.

The invention as set forth in claim 10 is to provide the method for designing a digital filter according to claim 9, characterized by further comprising the step of determining a transfer function of a low-band rejection filter, having a low-band rejection characteristic in a frequency band in which a noise component including the quantization error is caused, based on the frequency versus gain relation for the determined transfer function of the low-band rejection filter.

BRIEF DESCRIPTION OF THE DRAWINGS

| | |
|---|---|
| Fig. 1 | is a block diagram illustrating the configuration of a conventional digital filter. |
| Fig. 2A and 2B | are views illustrating the configuration of a typical digital filter which the digital filter shown in Fig. 1 is based on. |
| Fig. 3 | is a block diagram illustrating the configuration of a digital filter according to an embodiment of the present invention. |
| Fig. 4 | is a block diagram illustrating the configuration of a digital filter according to a more specific example. |
| Fig. 5 | is a characteristic diagram illustrating the frequency versus gain characteristic of an open loop transfer function OP(z) employed for designing the digital filter shown in Fig. 4. |
| Fig. 6 | is a characteristic diagram illustrating the frequency versus phase characteristic of the open loop transfer function OP(z) employed for designing the digital filter shown in Fig. 4. |
| Fig. 7 | is a characteristic diagram illustrating the frequency versus gain characteristic of a low-band rejection filter employed for designing the digital filter shown in Fig. 4. |
| Fig. 8 | is a characteristic diagram illustrating an extracted portion of the frequency versus gain characteristic of the low-band rejection filter shown in Fig. 7. |
| Fig. 9 | is a view illustrating the waveforms of input and output signals assuming that there is no delay in the open loop transfer function of the digital filter shown in Fig. 4. |
| Fig. 10 | is a view illustrating the waveforms of input and output signals assuming that there is a delay in the open loop transfer function of the digital filter shown in Fig. 4. |

BEST MODE FOR CARRYING OUT THE INVENTION

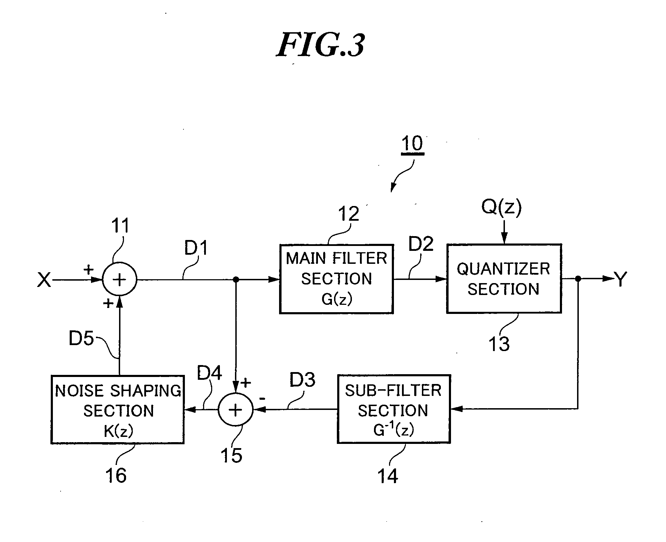

Now, with reference to Fig. 3, a description will be given of an embodiment for carrying out the present invention. Fig. 3 is a block diagram illustrating the configuration of a digital filter according to this embodiment.

In the drawing, the digital filter 10 is configured to have an adder 11; a main filter section 12 having a transfer function for applying an intended filter characteristic to an input signal X; a quantizer section 13; a sub-filter section 14 having an inverse transfer function from the main filter section 12; a subtracter 15; and a noise shaping section 16.

The adder 11 adds the input signal X and a feedback signal D5 output from the noise shaping section 16, and then supplies the resulting sum signal D1 to the main filter section 12 and the subtracter 15.

The main filter section 12 performs digital filtering on the sum signal D1 based on the aforementioned transfer function to thereby produce and output a signal obtained by applying an intended filter characteristic to the input signal X (hereinafter referred to as the "main filter signal") D2.

That is, the main filter section 12 is a main filter for applying an intended filter characteristic to the input signal X, and is formed of a filter that meets requirements such as design specifications. For example, to make adjustments to the frequency characteristic of the input signal X in various ways, the main filter section 12 is formed of an equalizer, while to pass the input signal X therethrough in its frequency band, the main filter section 12 is formed of a band-pass filter. On the other hand, to pass predetermined high-frequency components of the input signal X therethrough, it is formed of a high-pass filter, whereas to pass predetermined low-frequency components of the input signal X therethrough, it is formed of a low-pass filter. Additionally, the configuration of those filters can be determined as appropriate.

The quantizer section 13 re-quantizes the main filter signal D2 and then outputs the re-quantized signal as an output signal Y.

The sub-filter section 14 has an inverse transfer function from the main filter section 12, and outputs a signal (hereinafter referred to as the "sub-filter signal") D3 which is obtained by performing digital filtering on the output signal Y based on the inverse transfer function.

That is, with the transfer function of the main filter section 12 represented by $G(z)$ on the z-plane, the sub-filter section 14 is formed of a filter having the inverse transfer function $G^{-1}(z)$ from the transfer function $G(z)$. The sub-filter section 14 performs digital filtering on the output signal $Y(z)$ based on the transfer function $G^{-1}(z)$ to thereby output the sub-filter signal $D3(z)$ represented by $Y(z) G^{-1}(z)$.

The subtracter 15 computes the difference between the sum signal D 1 and the sub-filter signal D3, and then supplies the resulting differential signal D4 to the noise shaping section 16.

The noise shaping section 16 has a predetermined transfer function $K(z)$, described later, and performs computations on the differential signal D4 based upon the transfer function $K(z)$ to thereby create the feedback signal D5, which is in turn fed back to the adder 11 to be added to the input signal X. Note that the transfer function $K(z)$ of the noise shaping section 16 will be described later in more detail.

Then, in the digital filter 10 configured as such, suppose that an input signal X which has been oversampled at a frequency fs higher than the Nyquist frequency is supplied to the adder 11. In this case, the adder 11, the main filter section 12, the quantizer section 13, the sub-filter section 14, the subtracter 15, and the noise shaping section 16 perform digital computational operations on it in sync with the sampling cycle Ts (the reciprocal of the frequency fs) of the oversampling and perform the intended filtering on the input signal X based on the transfer function of the main filter section 12, allowing a re-quantized output signal Y to be delivered from the quantizer section 13.

Furthermore, the noise shaping section 16 provides a so-called noise shaping function, thereby allowing the quantizer section 13 to output a noise-shaped output signal Y.

That is, referring to Fig. 2B for description, suppose that the main filter section 12 defines, e.g., a filter characteristic having the audio band as a pass band, and the noise shaping section 16 defines a filter characteristic having a desired low-band rejection characteristic. In this case, the quantizer section 13 outputs the output signal Y which will cause a noise component such as a quantization error to be confined in a frequency band higher than the audio band. Accordingly, passing the output signal Y through a low-pass filter or the like having a high-band cutoff frequency at the upper limit of the audio band makes it possible to create an audio signal whose noise components such as a quantization error have been eliminated.

A description will now be made to the feature of the digital filter 10 according to this embodiment.
The output signal $Y(z)$ is expressed by Equation (2) below and the feedback signal $D5(z)$ is expressed by Equation (3) below, where the input signal X is represented by $X(z)$ on the z-plane, the output signal Y by $Y(z)$, the feedback signal D5 delivered from the noise shaping section 16 by $D5(z)$, the transfer function of the main filter section 12 by $G(z)$, the quantization noise introduced in the quantizer section 13 by $Q(z)$, the transfer function of the sub-filter section 14 by $G^{-1}(z)$, and the transfer function of the noise shaping section 16 by $K(z)$.

Accordingly, combining Equations (2) and (3) below together to eliminate the term of the feedback signal D5(z) gives the relation of the output signal $Y(z)$ to the input signal $X(z)$, i.e., the transfer function of the digital filter 10 expressed by Equation (4) below.

$$\underline{\text{Equation 2}}$$

$$Y(z) = \{X(z) + D5(z)\} \ G(z) + Q(z) \qquad \cdots (2)$$

Equation 3

$$D\,5(z) = \{X(z) + D\,5(z) - Y(z)\,G^{-1}(z)\}\,K(z) \qquad \cdots (3)$$

Equation 4

$$Y(z) = G(z)\,X(z) + \{1 - K(z)\}\,Q(z) \qquad \cdots (4)$$

Here, as can be seen in the first term on the right-hand side of Equation (4) above, the input signal X(z) is multiplied only by the transfer function G(z) of the main filter section 12, whereas as also can be seen in the second term on the right-hand side, the quantization noise Q(z) is multiplied by the transfer function K(z) of the noise shaping section 16.

That is, the transfer function G(z) of the main filter section 12 that is used for applying a desired filter characteristic to the input signal X(z) is clearly separated from the transfer function K(z) of the noise shaping section 16 that is used for noise shaping of noise components such as the quantization noise Q(z). Accordingly, this makes it possible to separately and independently adjust and design the main filter section 12 and the noise shaping section 16.

Then, in determining the transfer function K(z) of the noise shaping section 16, a low-band rejection filter is designed, as appropriate, which has a low-band rejection characteristic in a frequency band in which the quantization noise Q(z) to be eliminated is caused. Then, using the transfer function W(z) of the designed low-band rejection filter, based on the relation of Equation (5) below, a transfer function (1-W(z)) obtained by subtracting the transfer function W(z) from 1 is employed as the transfer function K(z) of the noise shaping section 16. Only this procedure makes it possible to readily design the noise shaping section 16.

Equation 5

$$W(z) = 1 - K(z) \qquad \cdots (5)$$

As such, the digital filter 10 of this embodiment is configured to allow the transfer function G(z) of the main filter section 12 and the transfer function K(z) of the noise shaping section 16 to be separately and independently designed. Therefore, this eliminates the need for considering effects that parameters such as orders and coefficients of each of the transfer function G(z) and K(z) have therebetween. Accordingly, this eliminates the need for such design works as described in the Background Art, and makes it possible to readily design a digital filter having an intended filter characteristic.

On the other hand, as expressed by Equation (1) above, the digital filter 1 of the conventional technique allows the transfer function H(z) of the noise shaping section 4 and the transfer function G(z) of the audio filter section not to be independently separated from each other. Therefore, although a digital filter having a fixed filter characteristic could be created, it was difficult to realize a so-called equalizer or the like for appropriately making gain adjustments or the like to the input signal X.

In contrast to this, the digital filter 10 of this example is configured such that the transfer function G(z) of the main filter section 12 and the transfer function $G^{-1}(z)$ of the sub-filter section 14 are independent of the transfer function K(z) of the noise shaping section 16. Therefore, an adjustment made only to the transfer functions G(z) and $G^{-1}(z)$ allows for providing desired equalizer characteristics. From this, the digital filter 10 of this example provides a good function as a so-called variable digital filter which is not only easy to design but also capable of making adjustments as appropriate to its filter characteristic even after it is completely assembled.

Furthermore, the digital filter 10 of this example is configured such that the transfer function G(z) of the main filter section 12 and the transfer function K(z) of the noise shaping section 16 are independently related to each other. Thus, the digital filter 10 provides a good function which allows for altering the noise shaping characteristic for noise components such as quantization noise only by changing the transfer function K(z) of the noise shaping section 16.

Furthermore, in the foregoing description, it was not made clear that the input signal X and the output signal Y were either a one-bit stream signal of PWM modulated waves or PDM modulated waves or a signal of a multi-bit data train. However, the digital filter 10 of this embodiment is applicable even to the cases where both the input signal X and the output signal Y are a multi-bit data signal or one-bit stream signal, or one of the input signal X and the output signal Y is a multi-bit data signal and the other is a one-bit stream signal.

That is, in the internal configuration of each of the adder 11, the main filter section 12, the quantizer section 13, the sub-filter section 14, the subtracter section 15, and the noise shaping section 16, such a portion of the configuration that allows for performing computational operations on a one-bit stream signal as it is can be configured to compute one-bit stream signals. On the other hand, such a portion of the configuration that requires multiplications or the like between pieces of multi-bit data may be configured to perform computational operations on data of a long bit length so as not to cause so-called rounding-off errors or the like.

Accordingly, the digital filter 10 of this embodiment is applicable regardless of whether the input signal X and the output signal Y are either a one-bit stream signal of PWM modulated waves or PDM modulated waves, or multi-bit data.

Additionally, the digital filter 10 of this embodiment can be implemented with hardware circuitry that employs so-called discrete circuits or integrated circuit devices (IC) as well as with digital signal processors (DSP) or micro-computer systems, which are adapted for digital computations.

A description will now be given of a method for designing the digital filter 10 of this embodiment.

Note that the description will be specifically directed to a method for designing the digital filter 10 using a computer system.

To begin with, the main filter section 12 shown in Fig. 3 is designed which has an intended transfer function G(z). Then, from the transfer function G(z) of the main filter section 12, the sub-filter section 14 having the transfer function $G^{-1}(z)$ is designed.

Then, a low-band rejection filter is designed which corresponds to the transfer function (1-K(z)) shown in the second term on the right-hand side of Equation (4) above. In other words, for example, the low-band rejection filter which provides such a low-band rejection characteristic as shown in Fig. 2B may be implemented as follows. That is, the configuration of a filter which can provide the low-band rejection characteristic is determined as appropriate, and then simulations are performed to optimize parameters such as the order and coefficients of the filter, thereby designing a low-band rejection filter which provides the intended low-band rejection characteristic.

Then, based on the relation given by Equation (5) above, the transfer function W(z) of the resulting low-band rejection filter is subtracted from 1, thereby determining the transfer function K(z) of the noise shaping section 16, i.e., the transfer function K(z) that is 1-W(z).

Then, as shown in Fig. 3, based on the transfer functions G(z), $G^{-1}(z)$, and K(z) which are determined through the processes described above, the main filter section 12, the sub-filter section 14, and the noise shaping section 16 are actually formed with electronic circuits. In addition, wiring is carried out therebetween including the adder 11, the quantizer section 13, and the subtracter 15, thus providing the digital filter 10 of this embodiment completed as such.

On the other hand, a digital signal processor (DSP) or micro-computer system may be employed to implement the digital filter 10 of this embodiment, or a so-called running program for a micro-computer system or the like to execute may be implemented. To this end, based on the transfer functions G(z), $G^{-1}(z)$, and K(z) which have been determined, a computer program corresponding to the block configuration shown in Fig. 3 is created.

As can be seen from above, the digital filter 10 of this embodiment allows for separately and independently designing the transfer function G(z) of the main filter section 12 and the transfer function K(z) of the noise shaping section 16, thereby making its design method simplified and very easy to create.

Additionally, in the design method described above, after the transfer function G(z) of the main filter section 12 and the transfer function $G^{-1}(z)$ of the sub-filter section 14 have been determined, then the transfer function K(z) of the noise shaping section 16 is determined. However, since the digital filter 10 of this embodiment can be advantageously configured to allow for separately and independently designing the transfer functions G(z) and K(z), the order of designing these transfer functions G(z), $G^{-1}(z)$, and K(z) is not important, but they can be designed in an appropriate order.

On the other hand, to design a digital filter which is used for electronic devices, the transfer function K(z) of the noise shaping section 16 can be first designed. This provides an effect that the transfer function K(z) of the noise shaping section 16 needs not to be re-designed even when a change or an adjustment is subsequently made to the characteristics of the main filter section 12 and the sub-filter section 14.

Furthermore, since the transfer function K(z) of the noise shaping section 16 needs not to be re-designed, the noise shaping section 16 may be formed separately with an integrated circuit device (IC) or the like, or formed by so-called unitization. Then, when various digital filters with the main filter section 12 having different filter characteristics are formed, the unitized noise shaping section 16 may be connected between the adder 11 and the subtracter 15.

As described above, the noise shaping section 16 unitized in advance can be provided as a versatile electronic component for designing digital filters.

Example

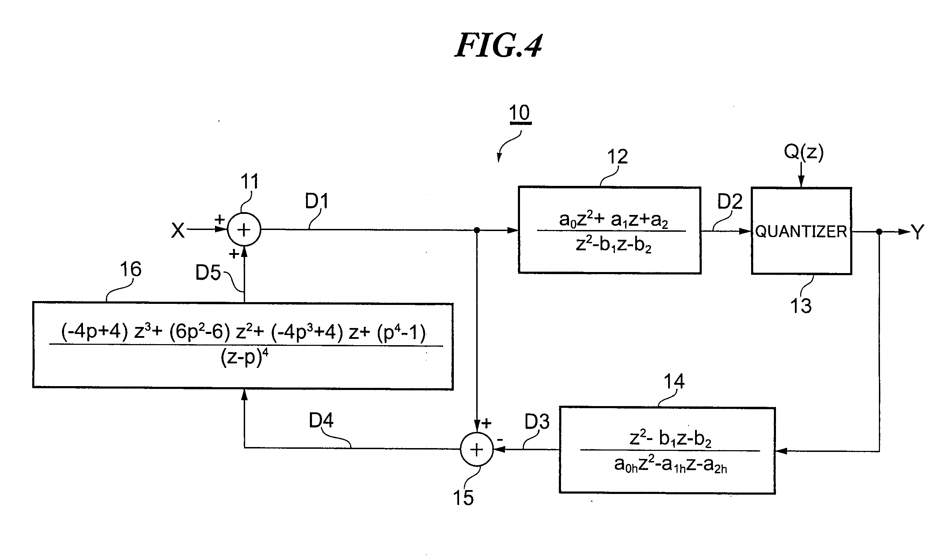

A description will now be given of a more specific example with reference to Fig. 4 to Fig. 10. Note that Fig. 4 is a block diagram illustrating the configuration of an audio digital filter of this example, with those portions similar or corresponding to those of Fig. 3 being indicated with the same symbols.

Additionally, the digital filter 10 is a so-called audio graphic equalizer which is configured to receive a one-bit stream digital audio signal (one-bit input signal) X that is read on a storage medium such as a CD or DVD (Digital Versatile Disc) and apply an intended filter characteristic thereto, then re-quantizing the resulting signal to output a one-bit stream one-bit output signal Y. The digital filter 10 is applicable to CD players, DVD players, or digital audio devices which allow the speaker to sound via a D-class amplifier or the like.

Description is now made to the configuration of the digital filter 10 with reference to Fig. 4. Like the digital filter shown in Fig. 3, the digital filter 10 is configured to have the adder 11, the main filter section 12, the quantizer section 13, the sub-filter section 14, the subtracter 15, and the noise shaping section 16.

Here, the adder 11 adds a one-bit input signal X and a multi-bit feedback signal D5 from the noise shaping section 16, and then outputs a multi-bit sum signal D1. As such, the adder 11 only adds the one-bit stream signal and the multi-bit signal, and thus can be implemented in a simple configuration, thereby contributing to the simplification of the configuration of the digital filter 10.

The main filter section 12, which has the transfer function G(z) expressed by Equation (6) below to apply an intended filter characteristic to the one-bit input signal X, receives the sum signal D 1 to output the main filter signal D2.

### Equation 6

$$G(z) = \frac{a_0 z^2 + a_1 z + a_2}{z^2 - b_1 z - b_2} \quad \cdots (6)$$

Then, coefficients $a_0$, $a_1$, $a_2$, $b_1$, and $b_2$ are set to predetermined coefficient values, thereby realizing a graphic equalizer which has the audio band as a pass band.

Note that this example employs a graphic equalizer as the main filter section 12; however, a low-pass filter, a band-pass filter, a high-pass filter, or other various types of filters may also be employed according to design specifications or the like.

The quantizer section 13, which is formed of a comparator for comparing a predetermined threshold THD with the main filter signal D2, outputs a one-bit output signal Y of a one-bit stream which has binary levels of logic "1" or "0" according to the magnitude of the level of the main filter signal D2 with respect to the threshold THD.

The sub-filter section 14, which has the inverse transfer function $G^{-1}(z)$ from the transfer function G(z), performs filtering on the one-bit output signal Y to output the sub-filter signal D3. That is, the sub-filter section 14 has the transfer function $G^{-1}(z)$_expressed by Equation (7) below.

### Equation 7

$$G^{-1}(z) = \frac{z^2 - b_1 z - b_2}{a_{0h} z^2 - a_{1h} z - a_{2h}} \quad \cdots (7)$$

Here, the coefficients $b_1$, $b_2$, $a_{0h}$, $a_{1h}$, and $a_{2h}$ in Equation (7) above are coefficient values which occur when the inverse transfer function $G^{-1}(z)$ is derived from the transfer function G(z).

The subtracter 15 subtracts the sub-filter signal D3 from the sum signal D1, and then supplies the resulting differential signal D3 to the noise shaping section 16.

The noise shaping section 16, which has the same transfer function K(z) as the one described in relation to Equation (5) above, performs filtering on the differential signal D3 based on the transfer function K(z), thereby creating a feedback signal D1 to be supplied to the adder 11.

Here, the transfer function K(z) is determined as follows.

To begin with, as described in the embodiment, the transfer function W(z) of the low-band rejection filter is the transfer function of the output signal Y(z) to the quantization noise Q(z), which is expressed by subtracting the transfer function K(z) from 1. The transfer function W(z) of the low-band rejection filter is determined as a simple transfer function that is expressed by Equation (8) below.

Equation 8

$$W(z) = 1 - K(z) = \frac{(z-1)^n}{(z-p)^n} \qquad \cdots (8)$$

Then, the order n of the transfer function W(z) is determined so that the cutoff characteristic at a cutoff frequency for eliminating quantization noise or the like conforms to the requirements of the design specification or the like. For example, to provide a steep cutoff characteristic, the order n is increased. Accordingly, when the low-band rejection filter is designed as a fourth order filter, its transfer function W(z) is expressed by Equation (9) below.

Equation 9

$$W(z) = 1 - K(z) = \frac{(z-1)^4}{(z-p)^4} \qquad \cdots (9)$$

The coefficient p in Equation (9) above, or a parameter serving as a pole of the transfer function W(z), is provided with a so-called optimized value, thereby determining a stable low-band rejection filter which has a phase margin in terms of a frequency versus gain and phase relation. Then, in the case of the fourth order low-band rejection filter, once the value of the coefficient p of the stable transfer function W(z) is determined, the noise shaping section 16 having the transfer function K(z) expressed by Equation (10) below is determined from the relation given by Equation (9) above.

Equation 10

$$K(z) = \frac{(-4p+4)\,z^3 + (6p^2-6)\,z^2 + (-4p^3+4)\,z + (p^4-1)}{(z-p)^4} \qquad \cdots (10)$$

In the digital filter 10 configured as described above, the one-bit input signal X which is oversampled at a the frequency fs higher than the Nyquist frequency may be supplied to the adder 11. In this case, the adder 11, the main filter section 12, the quantizer section 13, the sub-filter section 14, the subtracter 15, and the noise shaping section 16 perform digital computational operations on it in sync with the sampling cycle Ts (the reciprocal of the frequency fs) of the oversampling and perform filtering on the one-bit input signal X based on the transfer function G(z) of the main filter section 12, allowing a re-quantized one-bit output signal Y to be delivered from the quantizer section 13. The quantizer section 13 then outputs a one-bit output signal Y which is noise shaped by the function of the noise shaping section 16.

A description will now be given of a method for designing the digital filter 10 of this example.
Note that the description will be directed to a method for designing the digital filter 10 using a computer system. Furthermore, for convenience of the explanation, the description is directed to a case where the noise shaping section 16 is designed from the fourth order low-band rejection filter expressed by Equation (9) above.

To begin with, the main filter section 12 having the transfer function G(z) shown in Fig. 4 is designed, and then the inverse transfer function $G^{-1}(z)$ of the main filter section 12 is employed as the transfer function of the sub-filter section 14. The transfer function $G^{-1}(z)$ shown in Equation (7) above is thus determined.

Then, the transfer function W(z) of the simple low-band rejection filter shown in Equation (9) above is designed by simulation.

Here, to design the transfer function W(z) which provides good stability, the optimum value of the coefficient p of an open loop transfer function OP(z) expressed by Equation (11) below is analyzed and determined by simulation.

For example, with the main filter section 12 being disconnected from the quantizer 13, the transfer function OP(z) of the open loop from the input terminal of the quantizer 13 to the output terminal of the main filter section 12 is simulated.

Equation 11

$$OP(z) = \frac{K(z)}{1 - K(z)}$$

$$= \frac{(-4p+4)\ z^3 + (6p^2-6)\ z^2 + (-4p^3+4)\ (p^4-1)\ z}{(z-1)^4} \quad \cdots (11)$$

Then, the coefficient p of the open loop transfer function OP(z) expressed by Equation (11) above is varied within the range of from -1 to +1 to analyze the frequency versus gain and phase characteristic by simulation. Varying the coefficient p within the range of from real number -1 to +1 in this manner corresponds to varying the coefficient p associated with a pole within the range (the stable range) of a unit circle on the z-plane, and is thus preferred means for positively deriving a stable transfer function W(z).

As can be seen from the results of analysis obtained by such a simulation and allowed to appear on a display or the like, the frequency versus gain characteristic of the transfer function OP(z) as shown in Fig. 5 is obtained which employs the coefficient p as a parameter. Additionally, the frequency versus phase characteristic of the transfer function OP(z) as shown in Fig. 6 is obtained which employs the coefficient p as a parameter. Furthermore, the frequency versus gain characteristic of the transfer function W(z) of the low-band rejection filter is simulated while the coefficient p is being varied within the range of from real number -1 to +1, and is then allowed to appear on a display or the like. The results shown in Fig. 7 are thus obtained.

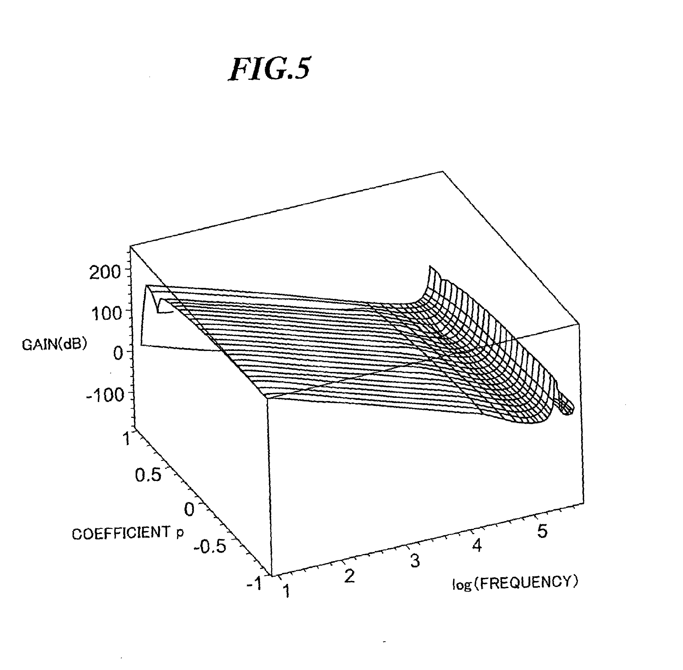

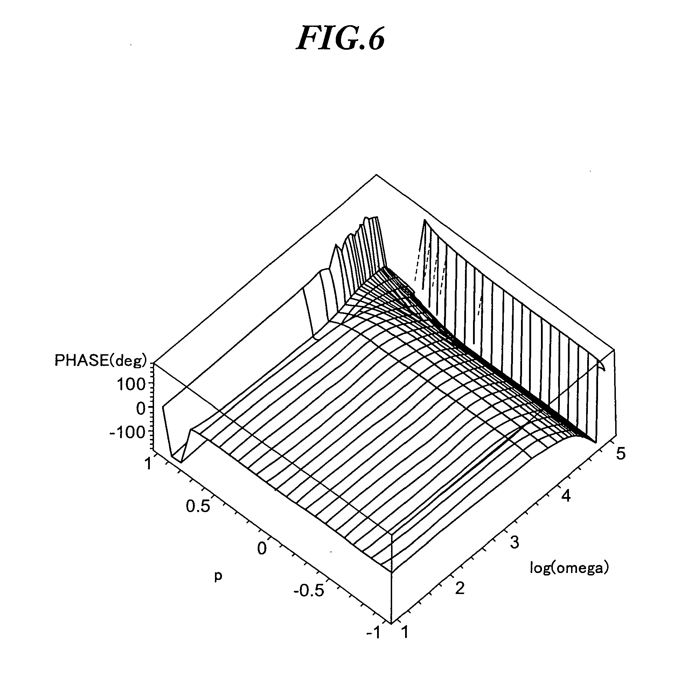

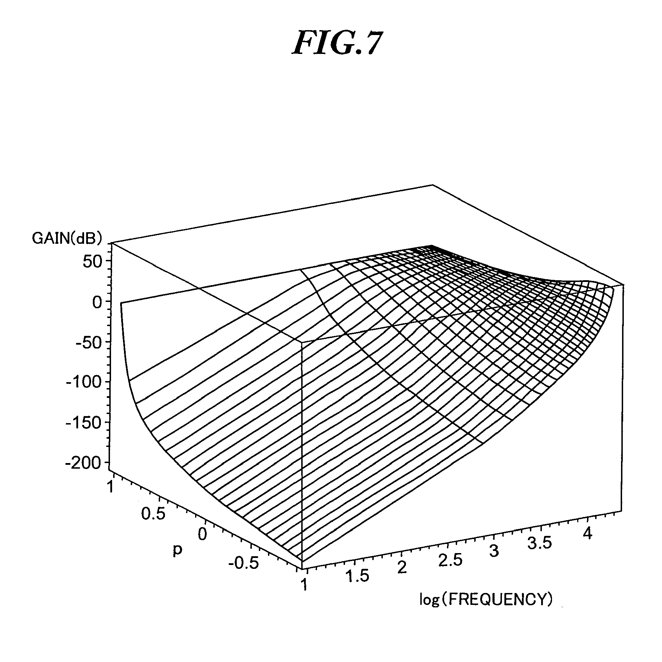

In this context, the frequency versus gain characteristic (see Fig. 5) and the frequency versus phase characteristic (see Fig. 6) of the transfer function OP(z), and the frequency versus gain characteristic (see Fig. 7) of the transfer function W(z) are analyzed. Then, the coefficient p is first selected under the conditions in which the transfer function OP(z) of Figs. 5 and 6 provides a sufficient phase margin with stability, and thereafter, a check is made to determine whether the frequency versus gain characteristic is representative of the desired low-band rejection characteristic when the selected coefficient p is applied to the transfer function W(z). In this manner, the transfer function W(z) which is stable and indicative of the desired low-band rejection characteristic is determined.

In this regard, as is clear from the characteristics in Figs. 5, 6, and 7, it can be seen that the value of the coefficient p being 0.7 can make it possible to realize a low-band rejection filter which has a sufficient phase margin and satisfies the condition of the intended frequency versus gain characteristic.

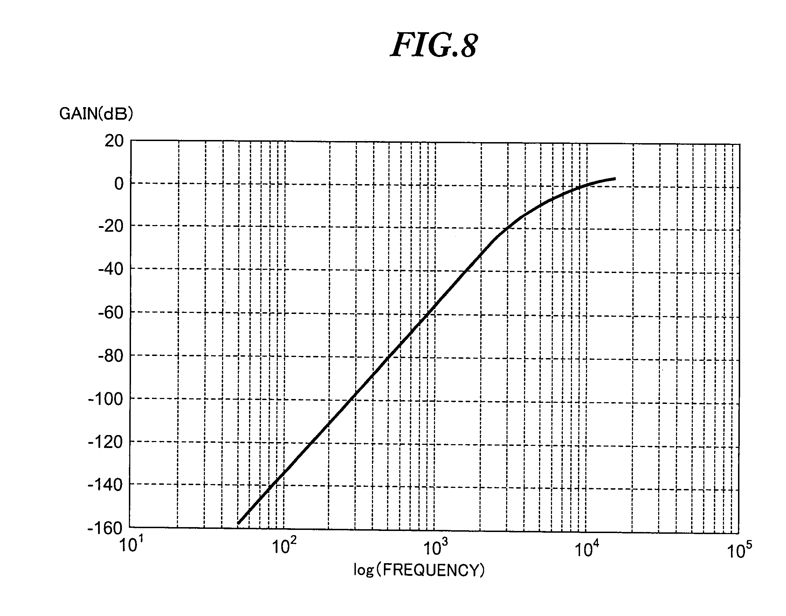

Fig. 8 is a view illustrating a frequency versus gain characteristic extracted from the characteristics of the transfer function W(z) of the low-band rejection filter shown in Fig. 7, with the value of the coefficient p being 0.7. Only by checking if such a frequency versus gain characteristic conforms to the intended low-band rejection characteristic, the transfer function W(z) of the low-band rejection filter can be easily determined.

Next, using the transfer function W(z) of the low-band rejection filter, the transfer function K(z) of the noise shaping section 16 is derived from the relation given by Equation (9) above, thereby determining the transfer function K(z) shown in Equation (10) above.

Then, based on the transfer functions G(z), $G^{-1}(z)$, and K(z) which are determined through the processes described above, the digital filter 10 shown in Fig. 4 is formed, and thus the design work of the digital filter 10 is ended.

A description will now be given of the features of the digital filter 10 of this example.

Like the digital filter of the embodiment shown in Fig. 3, the digital filter 10 of this example is configured to allow for separately and independently designing the transfer function G(z) of the main filter section 12 and the transfer function K(z) of the noise shaping section 16. It is thus possible to adjust or design each of the coefficients $a_0$, $a_1$, $a_2$, $b_1$, $b_2$, $a_{0h}$, $a_{1h}$, and $a_{2h}$ shown in Equations (7) and (8) above separately and independently of the noise shaping section 16. This makes it possible to easily and accurately design a digital filter having an intended filter characteristic.

Furthermore, the transfer function W(z) of the low-band rejection filter that is used to derive the transfer function K(z) of the noise shaping section 16 is given a simple configuration with a less number of parameters shown in Equation (8) above (i.e., the coefficient p and order n). Therefore, in checking or analyzing the stability of the phase margin or the like of the digital filter 10, a simulation can be easily performed and allowed to appear on a display or the like to thereby easily conduct the analysis or the like, thus facilitating design works or the like.

The digital filter 10 of this example also ensures that the main filter section 12 and the sub-filter section 14 are independent of the noise shaping section 16. Thus, the noise shaping section 16 can be separately formed with an integrated circuit device (IC) or the like, or formed by so-called unitization, so as to be connected between the adder 11 and the subtracter 15.

Additionally, the digital filter 10 of this example is capable of processing both the input and output signals X and Y as a one-bit stream signal, and can be thus employed for a digital system that uses the Delta-Sigma Modulation scheme, thereby advantageously providing improved SN ratios.

Additionally, from the results of analysis to be described below, the digital filter 10 of this example is suitably formed using a digital signal processor (DSP).

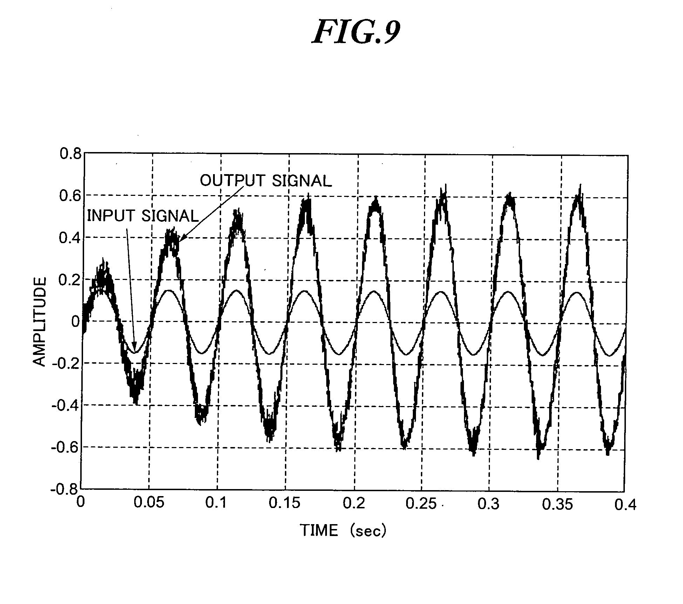

That is, as shown in Fig. 9, assuming that there is no time delay in the open loop transfer function of the digital filter 10, an output signal to an input signal was simulated to allow each signal to appear on a display as an analog signal, for convenience sake.

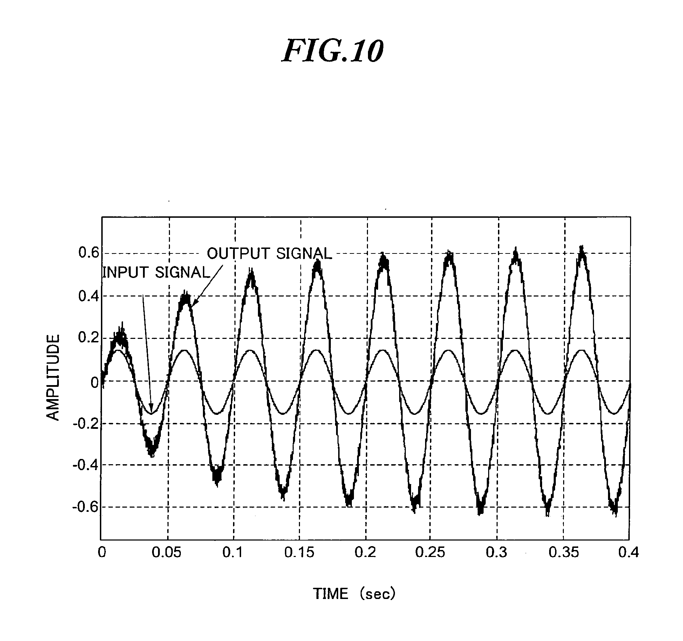

As shown in Fig. 10, assuming that there exists a delay time of one hundredth of the sampling cycle Ts in the open loop transfer function of the digital filter 10, an output signal was simulated when an input signal was received to allow each signal to appear on a display as an analog signal, for convenience sake.

A comparison between the waveforms of each signal in Fig. 9 and Fig. 10 shows that even with a delay time of 0.01 Ts, the waveform of the output signal during the transient response to the input signal is stable without any distortion, while the waveform of the output signal is also stable without any distortion after a transition from the transient response period to the steady state.

As a result, it can be concluded that even though the design method of this example is a simple one, the method allows for designing the digital filter 10 to have a sufficient phase margin, so that even in the presence of a delay time in a closed loop, the digital filter 10 would never be unstable and provide generally the same response characteristic as in the absence of a delay.

This means that the digital filter 10 of this example is suitably implemented in a digital signal processor (DSP) that takes much time to perform digital operations.

Furthermore, the effect that the digital filter 10 of this example is suitably implemented in a digital signal processor enables it to be used in a wide variety of electronic devices.

For example, the digital filter can be used not only for CD players or DVD players but also in the field of telecommunications such as for digital filters which perform digital filtering on intermediate frequency signals, demodulated signals, or detected signals in a digital tuner that receives digital broadcast.

Additionally, not only the digital filter 10 of this example but also the digital filter of the aforementioned embodiment are applicable to the field of telecommunications as well as to the field of automatic control.

Additionally, the digital filter 10 described in the embodiment and the example is adapted to keep the main filter section 12 and the sub-filter section 14 independent of the noise shaping section 16, and is thus also available as a graphic equalizer with each coefficient of the main filter section 12 and the sub-filter section 14 being variable.

As described above, the digital filter 10 described in the embodiment and the example has a very good versatility and is applicable to a wide variety of digital signal processing systems.

**Claims**

1. A digital filter for applying an intended filter characteristic to an input signal sampled at a frequency higher than the Nyquist frequency for output, **characterized by** comprising:

   main filter means, having a transfer function which provides an intended filter characteristic, for filtering an input signal based on said transfer function;
   quantization means for re-quantizing an output from said main filter means to output an output signal;
   sub-filter means, having an inverse transfer function from said transfer function of said main filter means, for filtering said output signal based on said inverse transfer function;
   noise shaping means, having a transfer function created by allowing a transfer function of a low-band rejection filter to be subtracted from 1, for filtering an input signal based on said transfer function, the low-band rejection filter having a low-band rejection characteristic in a predetermined frequency band of a noise component including a quantization error caused at said quantization means;
   first computation means for adding said input signal and an output from said noise shaping means to supply said resulting sum signal to said main filter means; and
   second computation means for computing the difference between said sum signal supplied to said main filter means and the output from said sub-filter means to supply said resulting differential signal to said noise shaping means.

2. The digital filter according to claim 1, **characterized in that** said noise shaping means is formed of a removably connected unit.

3. The digital filter according to claim 1 or 2, **characterized in that** the transfer function of said low-band rejection filter is configured to be expressed by a transfer function $(z-1)^n/(z-p)^n$ on the z-plane, where an arbitrary natural number n is its order and a coefficient p corresponds to its pole.

4. A digital filtering method for applying an intended filter characteristic to an input signal sampled at a frequency higher than the Nyquist frequency for output,
**characterized by** comprising:

   a main filter process, having a transfer function which provides an intended filter characteristic, for filtering an input signal based on said transfer function;
   a quantization process for re-quantizing an output created in said main filter process to output an output signal;
   a sub-filter process, having an inverse transfer function from said transfer function in said main filter process, for filtering said output signal based on said inverse transfer function;
   a noise shaping process, having a transfer function created by allowing a transfer function of a low-band rejection filter to be subtracted from 1, for filtering an input signal based on said transfer function, the low-band rejection filter having a low-band rejection characteristic in a predetermined frequency band of a noise component including a quantization error caused in said quantization process;
   a first computation process for adding said input signal and an output created in said noise shaping process to supply said resulting sum signal to said main filter process; and
   a second computation process for computing the difference between said sum signal supplied to said main filter process and the output produced in the sub-filter process to supply said resulting differential signal to said noise shaping process.

5. A computer program which realizes a digital filter for applying an intended filter characteristic to an input signal sampled at a frequency higher than the Nyquist frequency for output, **characterized by** comprising:

   a main filter step, having a transfer function which provides an intended filter characteristic, for filtering an input signal based on said transfer function;
   a quantization step for re-quantizing an output created in said main filter step to output an output signal;
   a sub-filter step, having an inverse transfer function from said transfer function in said main filter step, for filtering said output signal based on said inverse transfer function;
   a noise shaping step, having a transfer function created by allowing a transfer function of a low-band rejection filter to be subtracted from 1, for filtering an input signal based on said transfer function, the low-band rejection filter having a low-band rejection characteristic in a predetermined frequency band of a noise component including a quantization error caused in said quantization step;
   a first computation step for adding said input signal and an output created in said noise shaping step to supply said resulting sum signal to said main filter step; and
   a second computation step for computing the difference between said sum signal supplied to said main filter step and the output produced in the sub-filter step to supply said resulting differential signal to said noise shaping step.

6. A method for designing a digital filter which applies an intended filter characteristic to an input signal sampled at a frequency higher than the Nyquist frequency for output, the digital filter including: main filter means having a transfer function which provides an intended filter characteristic for an input signal; quantization means for re-quantizing an output from said main filter means to output an output signal; sub-filter means for filtering said output signal for output; computation means for computing the difference between the signal supplied to said main filter means and the output from said filter means to output the resulting differential signal; noise shaping means for filtering said differential signal for output; and another computation means for adding an output from said noise shaping means and said input signal for delivery to said main filter means, the method being
**characterized by** comprising the steps of:

   creating sub-filter means, having an inverse transfer function from said transfer function of said main filter means, for filtering said output signal based on said inverse transfer function; and

creating a transfer function of said noise shaping means by appropriately determining a transfer function of a low-band rejection filter having a low-band rejection characteristic in a frequency band in which a noise component including a quantization error is caused, and by subtracting the transfer function of said low-band rejection filter from 1.

**7.** The method for designing a digital filter according to claim 6, **characterized in that** said noise shaping means is formed of a removably connected unit.

**8.** The method for designing a digital filter according to claim 6 or 7, **characterized in that** the transfer function of said low-band rejection filter is configured to be expressed by a transfer function $(z-1)^n/(z-p)^n$ on the z-plane, where an arbitrary natural number n is its order and a coefficient p corresponds to its pole.

**9.** The method for designing a digital filter according to claim 8, **characterized by** further comprising the steps of: creating an open loop transfer function $K(z)/(1-K(z))$ based on a transfer function $K(z)$ obtained by subtracting the transfer function $(z-1)^n/(z-p)^n$ of said low-band rejection filter from 1; varying a coefficient p in said open loop transfer function $K(z)/(1-K(z))$ as a parameter within a range of from -1 to +1; determining a coefficient p in said open loop transfer function $K(z)/(1-K(z))$ with a phase margin based on frequency versus gain and frequency versus phase relations; and determining a transfer function of said low-band rejection filter by employing said resulting coefficient p.

**10.** The method for designing a digital filter according to claim 9, **characterized by** further comprising the step of determining a transfer function of a low-band rejection filter, having a low-band rejection characteristic in a frequency band in which a noise component including said quantization error is caused, based on a frequency versus gain relation for said determined transfer function of the low-band rejection filter.

FIG.1

ONE-BIT INPUT SIGNAL
X

1

PRIOR ART

EP 1 786 102 A1

ONE-BIT OUTPUT SIGNAL
Y

# FIG.2 A

INPUT
SIGNAL
X →

2

AUDIO FILTER
SECTION
G(z)

3

+ → (+) → 

+ ↑

4

NOISE SHAPING
SECTION
H(z)

Q(z)
↓

QUANTIZER
SECTION

OUTPUT
SIGNAL
→ Y

5

PRIOR ART

# FIG.2 B

GAIN(dB)

DESIRED LOW-BAND
REJECTION CHARACTERISTIC

0

-50

-100

-150

FREQUENCY

AUDIO BAND

PRIOR ART

# *FIG.3*

*FIG.4*

## FIG.5

# FIG.6

# FIG.7

FIG.8

GAIN(dB)

log(FREQUENCY)

EP 1 786 102 A1

*FIG.9*

# FIG.10

<table>
<tr><td colspan="2" align="center">**INTERNATIONAL SEARCH REPORT**</td><td colspan="2">International application No.<br>PCT/JP2005/015564</td></tr>
</table>

A.  CLASSIFICATION OF SUBJECT MATTER
*H03H17/02* (2006.01), *H03H17/04* (2006.01), *H03M3/02* (2006.01)

According to International Patent Classification (IPC) or to both national classification and IPC

B.  FIELDS SEARCHED

Minimum documentation searched (classification system followed by classification symbols)
*H03H17/02* (2006.01), *H03H17/04* (2006.01), *H03M3/02* (2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2000-341130 A  (Mitsubishi Electric Corp.),<br>08 December, 2000 (08.12.00),<br>Par. No. [0003]; Fig. 13<br>& US 6323794 B1 | 1-10 |
| A | JP 61-158220 A  (Sony Corp.),<br>17 July, 1986 (17.07.86),<br>Page 3, upper left column, line 1 to page 5,<br>lower left column, line 15; Fig. 1<br>(Family: none) | 1-10 |
| A | JP 6-85688 A  (Casio Computer Co., Ltd.),<br>25 March, 1994 (25.03.94),<br>Par. Nos. [0019] to [0021]; Fig. 1<br>(Family: none) | 1-10 |

☐  Further documents are listed in the continuation of Box C.    ☐  See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| | |
|---|---|
| Date of the actual completion of the international search<br>    15 November, 2005 (15.11.05) | Date of mailing of the international search report<br>    22 November, 2005 (22.11.05) |
| Name and mailing address of the ISA/<br>    Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **N. M. CASEY ; JAMES A. S. ANGUS.** One Bit Digital Processing Audio Signals. *Proc. Audio Eng. 95th AES Convention,* 1993